# EUROPÄISCHE PATENTSCHRIFT

(11) **EP 2 373 829 B1**
(45) Veröffentlichungstag und Bekanntmachung des Hinweises auf die Patenterteilung: **07.03.2018**
(21) Anmeldenummer: 09784069.8
(22) Anmeldetag: 02.12.2009
(51) Int. Cl.: C23C 16/40, F24C 15/16

(54) **VERFAHREN ZUR HERSTELLUNG VON BESCHLÄGEN, SEITENGITTERN UND GARGUTTRÄGERN FÜR HOCHTEMPERATURANWENDUNGEN UND METALLISCHES BAUTEIL**
PROCESS FOR MANUFACTURING FITTINGS, COOKING OVEN RAILS, GRATES OR TRAYS FOR HIGH TEMPERATURE APPLICATIONS AND PRODUCT THUS OBTAINED
PROCEDE DE FABRICATION DE FERRURES, GRILLES, RAILS OU PLAQUES DE FOUR POUR UTILISATION HAUTE TEMERATURE ET PRODUIT AINSI OBTENU

(30) Priorität: 02.12.2008 DE 102008059909
(43) Veröffentlichungstag der Anmeldung: 12.10.2011
(73) Patentinhaber: Paul Hettich GmbH & Co. KG, 32278 Kirchlengern (DE)
(72) Erfinder: JÄHRLING, Peter, 32257 Bünde (DE); GRIGAT, Willi, 33332 Gütersloh (DE)
(74) Vertreter: Dantz, Jan Henning
(86) Internationale Anmeldenummer: PCT/EP2009/066231
(87) Internationale Veröffentlichungsnummer: WO 2010/063759

(56) Entgegenhaltungen:
- EP-A1- 1 580 299
- WO-A1-2008/117905
- WO-A1-2011/032982
- GB-A- 2 362 845

## Beschreibung

Die Erfindung betrifft ein Verfahren nach dem Oberbegriff des Anspruchs 1, ein metallisches Bauteil nach dem Oberbegriff des Anspruchs 8, sowie eine Verwendung dieses Bauteils. Bei der Herstellung von Beschlägen. Seitengittern und Gargutträgern ist es bekannt, Bauteile aus selbst passivierenden nichtrostenden Stählen zu fertigen. Es erfolgt eine Oberflächenpassivierung meist bei einem Chromgehalt größer als 12 % wodurch sich eine Chromoxidschicht mit einer Stärke von 2-4 Nanometern ausbildet. Diese Passivschicht schützt das Bauteil vor Korrosion und verhindert den direkten Kontakt des Metalls mit einem anderen Medium. Die Passivierung durch eine Chromoxidschicht hat den Vorteil, selbsttätig passivierend zu sein, das heißt, dass beim Abtragen des Chromoxids durch Kratzer auf der Oberfläche, sich sofort wieder neues passivierendes Chromoxid aus der darunterliegenden Chromschicht bei Kontakt mit Luftsauerstoff bildet.

Für die Bildung einer gleichmäßigen Passivschicht bei der Passivierung müssen jedoch neben dem Chromgehalt weitere Bedingungen erfüllt sein. Dies sind hauptsächlich eine metallisch reine Oberfläche und genügend Sauerstoff, um eine vollständige Oxidation entlang der Oberfläche zu gewährleisten. Sind diese Bedingungen nicht erfüllt, so kann sich bei hohen Temperaturen (Temperaturen ab 450 °C) keine spontane Oxidschicht bei selbst passivierenden nichtrostenden Stählen bilden, die Korrosionsbeständigkeit nimmt ab und es kommt zur Ausbildung einer porösen Chromoxidschicht in Folge von Verzunderung, welche nur noch geringen Korrosionsschutz ermöglicht. Daher erweist sich der Einsatz von selbst passivierenden nichtrostenden Stählen für die Fertigung von Bauteilen für Gar- und Backöfen im Anwendungsbereich ab 400 °C als unvorteilhaft.

Die gattungsgemäße EP 1 580 299 offenbart ein Kochgerät, bei dem eine metallische Oberfläche mit einer auf Silikonoxid basierenden Beschichtung versehen ist. Dadurch soll ein verbesserter Schutz gegen Oxidation, Korrosion und Abrieb erhalten werden.

Aufgabe der vorliegenden Erfindung ist es daher, ein Verfahren zu schaffen, welches die Korrosionsbeständigkeit von Seitengittern, Beschlägen und Gargutträgern verbessert. Zudem soll ein metallisches Bauteil für einen dauerhaften Einsatz in Backöfen im Hochtemperaturbereich geschaffen werden.

Die vorliegende Erfindung löst diese Aufgabe durch ein Verfahren mit den Merkmalen des Anspruchs 1, ein metallisches Bauteil mit den Merkmalen des Anspruchs 8 und eine Verwendung mit den Merkmalen des Anspruchs 15. Das Verfahren zur Herstellung von Beschlägen, Seitengittern und Gargutträgern für Hochtemperaturanwendungen, sieht das Herstellen eines metallischen Rohteils vor, insbesondere durch Stanzen und Biegen eines Metallbleches, sowie das Aufbringen einer Plasmapolymerschicht auf der Oberfläche des Rohteils, das Erhitzen des beschichteten Rohteils auf eine Temperatur von mindestens 400 °C und das Abkühlen des beschichteten Rohteils auf Raumtemperatur. Dadurch wird ein Rohteil geschaffen, das eine gute Korrosionsbeständigkeit auch bei hohen Temperaturen aufweist. Bei der Beschichtung von Bauteilen für den Einsatz in Backöfen zeigte sich überraschenderweise erst nach einer thermischen Behandlung die zuvor mit einer Plasmapolymerschicht versehene Oberfläche als genügend widerstandsfähig, um den Belastungstests zu genügen.

Erfindungsgemäß wird das Bauteil vor dem Aufbringen der Plasmapolymerschicht geglättet, um eine möglichst große Grenzfläche zwischen Polymer und Metalloberfläche zu erreichen und zudem einen geringen Abstand zwischen beiden Oberflächen zu erhalten. Das Bauteil wird vor der Beschichtung auf einer Oberflächenrauhigkeit von weniger als 400 nm, vorzugsweise 300 bis 400 nm, vorzugsweise weniger als 350 nm geglättert, was die Adhäsion des Polymers an der Metalloberfläche verbessert. Vor der Aufbringung der Plasmapolymerschicht können Reinigungsverfahren wie z.B. eine Entfettung zum Einsatz kommen.

Da die Schritte des Verfahrens auch automatisiert werden können, ist eine Anwendung in serieller Fertigung möglich. Die durch Plasmapolymerbeschichtung und thermische Behandlung erhaltene Oberfläche bewirkt einen verbesserten Korrosionsschutz auch im höheren Temperaturbereich gegenüber der bisherigen Passivierung.

Das Vorhandensein von polaren Gruppen in Folge der Plasmabehandlung ermöglicht zudem eine zusätzliche Vernetzung bei höheren Temperaturen von Polymersträngen untereinander und die Unordnung der Polymerstränge zur Ausbildung von Bindungen bis hin zur Ausbildung lokaler Kristallisationszonen. Diese Möglichkeiten haben eine Verfestigung des Polymermaterials, zusätzlich zu der Reißfestigkeit der amorphen Abschnitte des Polymers, zur Folge.

Diese zusätzliche Festigkeit der Plasmapolymeroberfläche in Folge der thermischen Behandlung macht sie daher resistenter gegenüber mechanischen Abriebs und sichert die wartungsfreie Nutzung der Bauteile, welches entsprechend dieses Verfahrens hergestellt wurde.

Diese Festigkeit wird durch eine Diffusion der Plasmapolymerverbindung in die Oberfläche des metallischen Rohteils unterstützt.
Vorzugsweise wird eine siliziumhaltige Plasmapolymerbeschichtung vorgesehen, die eine durchgehend feste SiO₂-Schicht bildet, welche sowohl die Korrosionsbeständigkeit erhöht, als auch Anlauffarben von Edelstählen kaschiert, die bei der thermischen Behandlung auftreten können.

Das plasmapolymerbeschichtete Rohteil wird vorzugsweise mindestens 20 Minuten, insbesondere mehr als 30 Minuten bei 400-600 °C getempert. Dadurch wird eine haftfest, korrosionsbcständige und weitgehend alterungsresistente Metall-Polymerverbindung erreicht. Die Zeit von mindestens 20 bzw. 30 Minuten ist von Vorteil, für die Vernetzung und Umorientierung der Polymerabschnitte. Weiterhin kann eine Erhitzung der Plasmapolymerschicht auf bis zu 800 °C zu einer robusteren, kompakten Schicht auf dem Rohteil führen.

Eine vorteilhafte Ausführungsform der Beschichtung sieht ein siliziumhaltiges Plasmapolymer vor, das im Bereich von 300-600 °C temperaturbeständig ist. Silizium-Sauerstoffpolymerverbindungen, beispielsweise Silicone, sind kostengünstig, unkompliziert zu synthetisieren und chemisch resistent gegenüber einem Großteil von Chemikalien. Aufgrund ihrer Materialeigenschaften finden derartige Polymere vielerlei Anwendungen als Baumaterialien oder auch Beschichtungsmaterial und erfüllen somit die Anforderungen, welche an Beschichtungsmaterial für die Hochtemperaturanwendung gestellt werden.

Die Wärmebehandlung der Plasmapolymerbeschichtung erfolgt vorteilhafterweise nach einem Temperaturprogramm, wobei in einer Aufheizphase des beschichteten Rohkörpers zwei unterschiedliche Temperaturgradienten verwendet werden. Zunächst geschieht das langsame Hochheizen des Rohteils von Raumtemperatur ϑ₀ =0-40 °C auf eine mittlere Temperatur ϑ₁ von 80-200 °C. Anschließend erfolgt eine deutlich schnellere Aufheizphase, um die entsprechende Zieltemperatur ϑ₂ zu erreichen. Somit wird der Beschichtung ermöglicht, sich bei der thermischen Ausdehnung des Rohteils auf die veränderten Bedingungen einzustellen und sich gegebenenfalls neu entlang der Metalloberfläche zu orientieren.

Es ist von Vorteil, die Zieltemperatur ϑ₂ für das Aufheizen der Beschichtung im Bereich 400-600 °C zu wählen, da diese Zieltemperatur der Temperatur bei der Pyrolysereinigung eines Backofens entspricht. Bei dieser Zieltemperatur ist eine Umorientierung von Polymersträngen möglich. Denn nach der Ausbildung von Bindungen der Polymerstränge untereinander ist eine weitere Umorientierung meist nicht mehr möglich, und kann entsprechenden mechanischen Belastungen, auch im Hochtemperaturbereich, standhalten.

Es ist zudem von Vorteil, die Zieltemperatur über einen Zeitraum von 15 bis 90 Minuten, vorzugsweise 25 bis 40 Minuten zu halten, da in diesem Zeitraum eine Umorientierung der Polymerketten gefolgt von der Ausbildung zusätzlicher Bindungen stattfinden kann.

Während der Abkühlphase empfiehlt sich ein hoher Temperaturgradient von beispielsweise 5-40 K/min, vorzugsweise 15-25 K/min, wodurch sowohl die Materialbelastbarkeit an der Grenzfläche durch unterschiedliche thermische Ausdehnung minimiert und als auch Fehlordnungen im Material verhindert werden.

In einer vorteilhaften Ausführungsform wird das beschichtete Rohteil bei einem Luftdurchsatz von 30-90 l/min, vorzugsweise 50-70 l/min getempert, wodurch eine Bindung des Plasmapolymers auf der Metalloberfläche geschaffen wird.

Es ist von Vorteil, wenn ein Metall insbesondere Chrom, in die Plasmapolymerschicht durch Erhitzen eindiffundiert, welches unter Sauerstoffeinfluss eine Passivschicht ausbildet, so dass bei der Beschädigung der Beschichtung des Bauteils, beispielsweise durch Kratzer sich eine Passivschicht bildet, welche die darunter angeordnete Metalloberfläche vor Korrosion schützt. Dabei bildet Chrom beispielsweise eine Oxidschicht aus. Somit ergänzen sich die Vorteile einer Chrombeschichtung mit den Vorteilen einer Plasmapolymerbeschichtung.

Diese Korrosionsschicht verlängert die Lebensdauer des Bauteils bei Beschädigung der durch das Plasmapolymer gebildeten obersten Schicht.

Um eine Diffusion zu gewährleisten kann das Erhitzen gesondert oder während des Aushärtens des beschichteten Bauteils mit der Plasmapolymerschicht erfolgen.

Ein mit dem erfindungsgemäßen Verfahren hergestelltes Bauteil ist insbesondere in Backöfen im Hochtemperaturbereich einsetzbar. Denn die Beschichtung bewirkt sowohl eine hohe Materialbelastbarkeit als auch eine hohe Temperaturbeständigkeit. In einem Backofen werden meist Lebensmittel gegart, die in der Regel viel Wasser entfalten, das verdunstet und sich an anderer Stelle niederschlägt. Dadurch ist bei Bauteilen in einem Backofen eine besondere Korrosionsanfälligkeit gegeben. Darüber hinaus sollte gerade in diesem Anwendungsbereich auf eine hygienisch hochwertige Verarbeitungsweise Wert gelegt werden.

Zudem hat es sich als vorteilhaft verwiesen, eine Plasmapolymerschicht von 50-500 nm, vorzugsweise 100-400 nm entlang der Oberfläche des Metalls auszubilden. Diese Schicht ermöglicht es, die Oberfläche des metallischen Bauteils sichtbar zu lassen, so dass das Bauteil als metallisches Bauteil wahrgenommen wird. Die Materialbeschaffenheit der transparenten Plasmapolymerschicht hat den Vorteil, dass mögliche Anlauffarben von Edelstählen kaschiert werden ohne den metallischen Glanz zu verlieren und somit im sichtbaren Bereich des Ofens einen optischen Effekt zu erzielen.

Es ist weiterhin vorteilhaft, wenn die Plasmapolymerschicht mindestens 5 %, vorzugsweise 20-30 % nach Masseanteilen ein Metall, insbesondere Chrom, aufweist, welches unter Sauerstoffeinfluss eine Passivschicht ausbildet, so dass Kratzer und Beschädigung der Beschichtung nicht zu einer Korrosion des darunterliegenden Metalls und zu einer Unterwanderung der Beschichtung führen, sondern sich auf dem Bereich der Beschädigung eine Passivschicht ausbildet.

Das Bauteil kann nach dem Aushärten der Plasmapolymerbeschichtung derart aufgebaut sein, dass das Bauteil aus mehreren Schichten besteht und zumindest eine Deckschicht, eine Zwischenschicht und einen Grundkörper aus Metall aufweist. Die Deckschicht weist dabei zumindest 80 %, vorzugsweise 90 % Siliziumoxid auf und dient als Nutzschicht gegenüber Abrieb, als auch Fettspritzer, Säuren, Laugen und mechanischer Beanspruchung (z.B. durch Feststoffe in Scheuermilch).

Die Zwischenschicht weist zumindest Siliziumoxid bzw. SiO₂ und zumindest ein Metall auf, welches bei Verletzung der Deckschicht durch Kratzer und dergleichen in Folge von Abnutzung eine Passivschicht zum Schutz vor Korrosion des Grundmaterials ausbildet. Während die Siliziumanteile für die Stabilität dieser Schicht sorgen, ermöglicht das Metall einen Korrosionsschutz. Die Zwischenschicht kann neben Siliziumoxid und dem Metall weitere Komponenten enthalten. Diese Anordnung ermöglicht vorteilhaft eine längere Lebensdauer von metallischen Bauteilen und gewährleistet eine gleichbleibende metallische Optik.

Das erfindungsgemäße Bauteil eignet sich besonders gut für die Herstellung einer Auszugsführung, insbesondere können die Schienen der Auszugsführung entsprechend beschichtet werden.

Bei diesem Bauteil wird das Material durch Reibung derart beansprucht, dass das erfindungsgemäße Verfahren hier eine gute Alternative für den Korrosionsschutz zu bisher bestehenden Verfahren darstellt.

Die Erfindung wird nachfolgen anhand eines Ausführungsbeispieles mit Bezug auf die beigefügten Zeichnungen näher erläutert. Es zeigen:

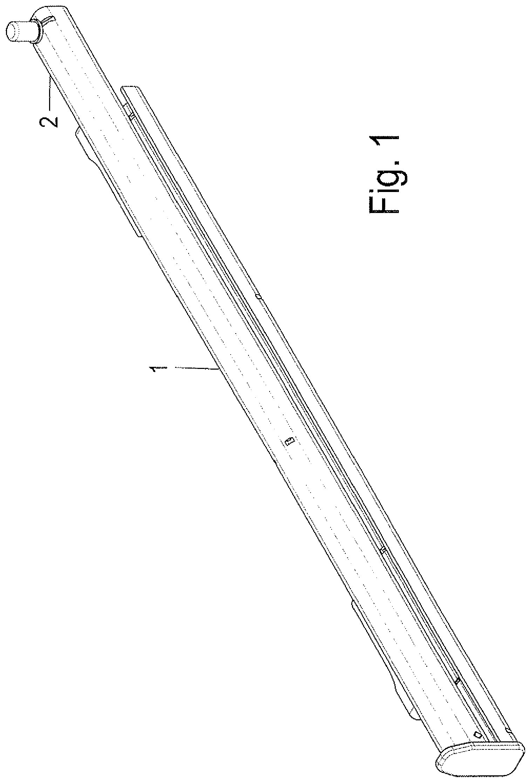

- Figur 1: eine perspektivische Ansicht einer erfindungsgemäßen Auszugsführung;

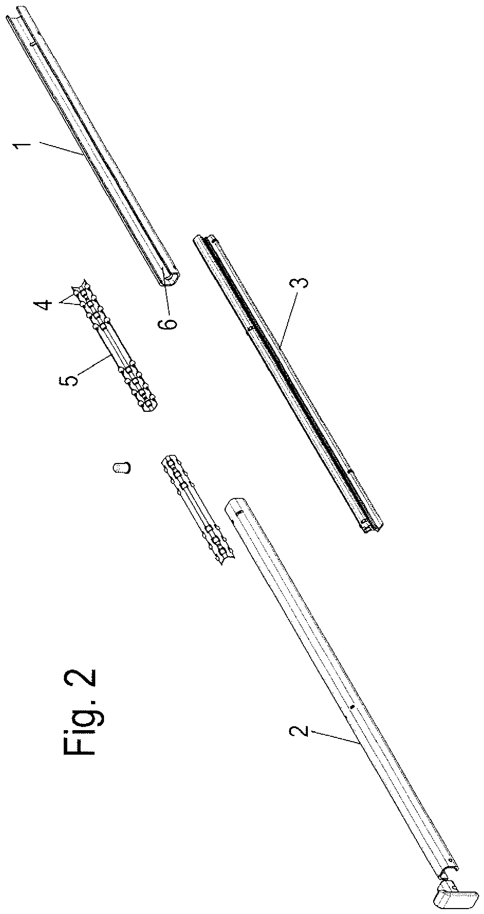

- Figur 2: eine Explosionsdarstellung der Auszugsführung der Figur1; und
- Figur 3: ein schematisches Temperaturdiagramm für das Herstellen eines beschichteten Bauteils
- Figur 4: schematisches Diagramm D1
- Figur 5: schematisches Diagramm D2
- Figur 6: Tabelle 6

Eine Auszugsführung für Hochtemperaturanwendungen, insbesondere für Backöfen, umfasst eine Führungsschiene 1 und eine relativ zur Führungsschiene bewegbare Laufschiene 2, zwischen denen eine Mittelschiene 3 gelagert ist. Es sind auch Auszugsführungen bekannt, die nur über eine Führungs- und eine Laufschiene verfügen. Des weiteren finden auch Auszugsführungen Verwendung die über eine Führungsschiene, eine Laufschiene und mehr als eine Mittelschiene verfügen. Für die verfahrbare Lagerung der Mittelschiene 3 und der Laufschiene 2 sind Wälzkörper 4, insbesondere aus Keramik, vorgesehen. Dabei sind an der Führungsschiene 1, der Mittelschiene 3 und der Laufschiene 2 jeweils mehrere Laufbahnen 6 für die kugelförmigen Wälzkörper 4 vorgesehen.

Die Schienen 1 bis 3 sind für den Einsatz in Backöfen aus einem gestanzten und gebogenen Stahlblech hergestellt und mit einer Beschichtung versehen. Die Herstellung der Bauteile der Auszugsführung, insbesondere der Schienen 1 bis 3 erfolgt durch die folgenden Schritte:
Zunächst werden die metallischen Rohteile durch Stanzen und Biegen hergesellt. Das Rohteil kann dabei maschinell gefertigt werden. Dann wird eine Plasmapolymerschicht auf der Oberfläche der Rohteile aufgebracht. Die beschichteten Rohteile werden dann auf eine Temperatur von mindestens 400 °C erhitzt und für eine vorbestimmte Zeitdauer getempert, bevor sie wieder auf Raumtemperatur abgekühlt werden.

Das Auftragen der Plasmapolymerschicht kann beispielsweise durch Funktionalisierung der Polymeroberflächen mit reaktiven, meist polaren Gruppen durch Plasmamodifikation und anschließendes Aufbringen dieser auf eine metallische Oberfläche erfolgen. Eine andere Möglichkeit ist eine direkte Plasmapolymerisation von Monomeren, die sich bereits auf einer metallischen Oberfläche befinden.

Ein Plasmapolymer hat eine funktionalisierte Oberfläche, dass heißt polare Gruppen, welche durch gezieltes Einwirken von Plasma gebildet werden. Diese funktionalisierte Oberfläche kann, neben Adhäsionskräften, auch kovalente Bindungen zwischen den polaren Gruppen der Polymeroberfläche und einer Metalloberfläche ausbilden. Die Grundstruktur des Polymers, vor der Plasmabehandlung ist ebenso maßgebend für die späteren Eigenschaften der Polymerbeschichtung wie die Plasmabestrahlung selbst. So kann eine plasmamodifizierte Teflonschicht, auf dem Metall anhaften jedoch zudem Wasser abweisen. Die Länge der Polymerkette an den Kontaktstellen (spacer) bestimmt deren Flexibilität. Vorteilhaft bei einer PlasmaBehandlung von Polymeren ist, dass die entstandenen funktionellen Gruppen chemisch so modifiziert werden können, dass sie sich der Metalloberfläche anpassen können.

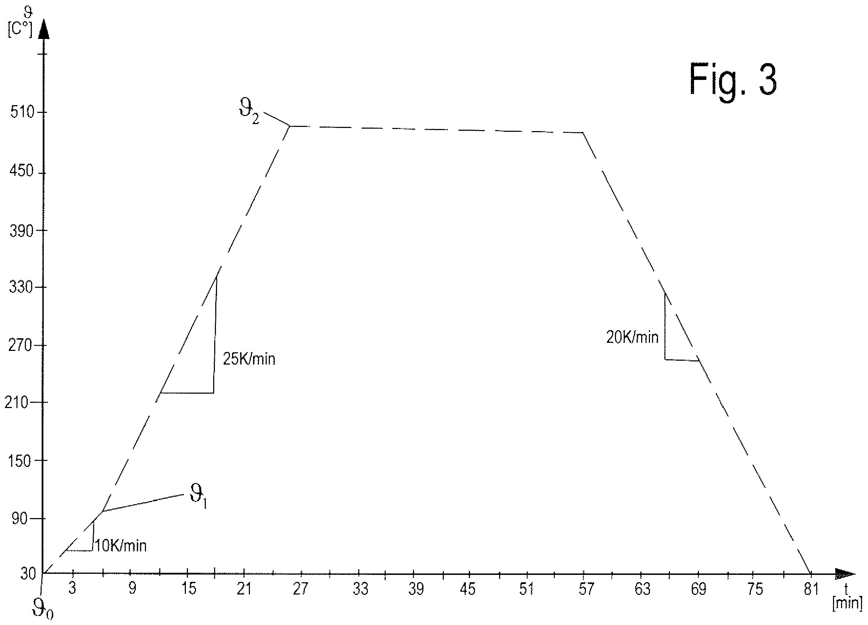

In Figur 3 ist schematisch ein Temperaturdiagramm für das Verfahren der dauerhaften Beschichtung von Beschlägen, Seitengittern und Gargutträgern für Hochtemperaturanwendungen dargestellt. Das beschichtete Rohteil wird zunächst von Umgebungstemperatur ϑ₀ erwärmt. Es beginnt mit einem Temperaturgradienten von 10 K/min ausgehend von einer Anfangstemperatur ϑ₀ von 25 C und geht dann bei einer mittleren Temperatur von ϑ₁=100 °C in einen Temperaturgradienten von 25 K/min über. Beim Erreichen einer Zieltemperatur ϑ₂ von 500 °C folgt ein Temperaturplateau über 30 min hinweg. Schließlich folgt eine Abkühlungsphase mit 15 K/min zurück zu ϑ₀.

In dem dargestellten Ausführungsbeispiel wurde eine Auszugsführung beschrieben. Es ist natürlich auch möglich, andere metallische Bauteile mit einer erfindungsgemäßen Beschichtung zu versehen. Insbesondere können Gargutträger, Seitengitter, Beschläge oder andere in Backöfen einsetzbare Bauteile beschichtet werden.

Nachfolgend sind die Ergebnisse einer Tiefenprofilanalyse einer plasmapolymerbeschichteten Auszugsführung aufgeführt. Die Tiefenprofilanalyse ist durch Glimmspanentladung nach ISO 14707 und ISO/DIS16962.2 bei 650V und 2hPa erfolgt.

| **Tab. 1** | **Siliziumoxid** - **Beschichtung, ohne Plasmapolymerbehandlung** | | | | | |
|---|---|---|---|---|---|---|
| **Tiefe [µm]** | **Fe [%]** | **C [%]** | **O [%]** | **Si [%]** | **Cr [%]** | **S [%]** |
| 0,030 | 5,530 | 6,210 | 6,000 | 76,691 | 3,672 | 0,189 |
| 0,120 | 60,310 | 3,162 | 2,399 | 0,551 | 31,297 | 0,081 |
| 0,210 | 63,380 | 1,189 | 1,144 | 0,402 | 32,296 | 0,034 |
| 0,300 | 66,120 | 0,657 | 0,621 | 0,336 | 30,981 | 0,019 |
| 0,700 | 72,990 | 0,156 | 0,163 | 0,263 | 25,575 | 0,003 |

| **Tab. 2** | **Siliziumoxid - Beschichtung ohne Plasma - nach 20 Pyrolysen** | | | | | |
|---|---|---|---|---|---|---|
| **Tiefe [µm]** | **Fe [%]** | **C [%]** | **O [%]** | **Si [%]** | **Cr [%]** | **S [%]** |
| 0,030 | 0,380 | 0,613 | 0,809 | 97,892 | 0,118 | 0,032 |
| 0,120 | 37,080 | 8,812 | 28,806 | 3,837 | 17,221 | 0,469 |
| 0,210 | 59,190 | 3,651 | 13,818 | 1,825 | 19,763 | 0,170 |
| 0,300 | 65,01 | 2,108 | 8,444 | 1,238 | 22,117 | 0,103 |
| 0,700 | 71,520 | 0,596 | 2,646 | 0,590 | 24,145 | 0,031 |

| **Tab. 3** | | **Plasma - ohne Pyrolyse** | | | | |
|---|---|---|---|---|---|---|
| **Tiefe [µm]** | **Fe [%]** | **C [%]** | **O [%]** | **Si [%]** | **Cr [%]** | **S [%]** |
| 0,030 | 1,550 | 7,026 | 7,737 | 80,836 | 1,573 | 0,163 |
| 0,120 | 6,580 | 13,883 | 17,789 | 56,967 | 3,668 | 0,155 |
| 0,210 | 58,580 | 3,607 | 4,504 | 3,681 | 28,714 | 0,061 |
| 0,300 | 64,810 | 0,838 | 1,294 | 1,020 | 31,478 | 0,020 |
| 0,700 | 72,34 | 0,233 | 0,314 | 0,395 | 26,339 | 0,004 |

| **Tab. 4** | | **Plasma - fünffache Pyrolyse** | | | | |
|---|---|---|---|---|---|---|
| **Tiefe [µm]** | **Fe [%]** | **C [%]** | **O [%]** | **Si [%]** | **Cr [%]** | **S [%]** |
| 0,030 | 0,685 | 3,232 | 2,935 | 91,923 | 0,201 | 0,100 |
| 0,120 | 15,107 | 12**,**222 | 28,711 | 40,311 | 2,083 | 0,226 |
| 0,210 | 46,194 | 2,154 | 16,011 | 4,070 | 31,874 | 0,047 |
| 0,300 | 74,150 | 0,447 | 3,163 | 1,109 | 18,910 | 0,016 |
| 0,700 | 76,600 | 0,148 | 0,578 | 0,411 | 20,711 | 0,003 |

| **Tab. 5** | | **Plasma - 20fache Pyrolyse** | | | | |
|---|---|---|---|---|---|---|
| **Tiefe [µm]** | **Fe [%]** | **C [%]** | **O [%]** | **Si [%]** | **Cr [%]** | **S [%]** |
| 0,030 | 0,360 | 1,026 | 1,062 | 97,091 | 0.201 | 0,039 |
| 0,120 | 17,760 | 14,313 | 23,826 | 40,764 | 2,083 | 0,229 |
| 0,210 | 44,770 | 6,222 | 32,387 | 9,771 | 6,013 | 0,099 |
| 0,300 | 64,700 | 1,661 | 11,495 | 2,891 | 18,910 | 0,024 |
| 0,700 | 77,070 | 0,161 | 1,219 | 0,491 | 20,711 | 0,003 |

Die aufgeführten Messergebnisse wurden an einer legierten Edelstahloberfläche Oberfläche aus einer Eisen-Chrom Legierung als Grundwerkstoff durchgeführt. Dabei wurde jeweils eine siliziumhaltige Beschichtung auf eine Auszugsführung aufgetragen. Die [%]-Angaben bezieht sich auf die vorherrschende Massekonzentration bei einer definierten Oberflächentiefe.

Die Ergebnisse der Tabelle 1 sind auf eine Polymerbeschichtung zurückzuführen, welche nicht im Vorfeld durch Plasmabehandlung funktionalisiert wurde.

Die Ergebnisse der Tabelle 2 ergeben sich ebenfalls aus der Analyse einer Polymerbeschichtung ohne Plasmabehandlung mit dem Grundwerkstoff, welche jedoch 20 Pyrolysenzyklen unterzogen wurde.

Ein Vergleich der Messwerte der Messwerte der Tabelle 1 mit der Tabelle 2 zeigt, dass der Eisen- und Chromgehalt bei einer Oberflächentiefe von 0,12 µm um über 1/3 gesunken ist, Zugleich ist die Massekonzentration des Sauerstoffs von 2,4 % auf 28,8 % gestiegen. Dies liegt an der Verzunderung des Eisenmaterials an der Oberfläche. Ein Siliziumoxidfilm bildet sich an der Oberfläche und dringt lediglich zu einem geringen Teil (1-3,5 %) in die metallische Oberfläche ein.

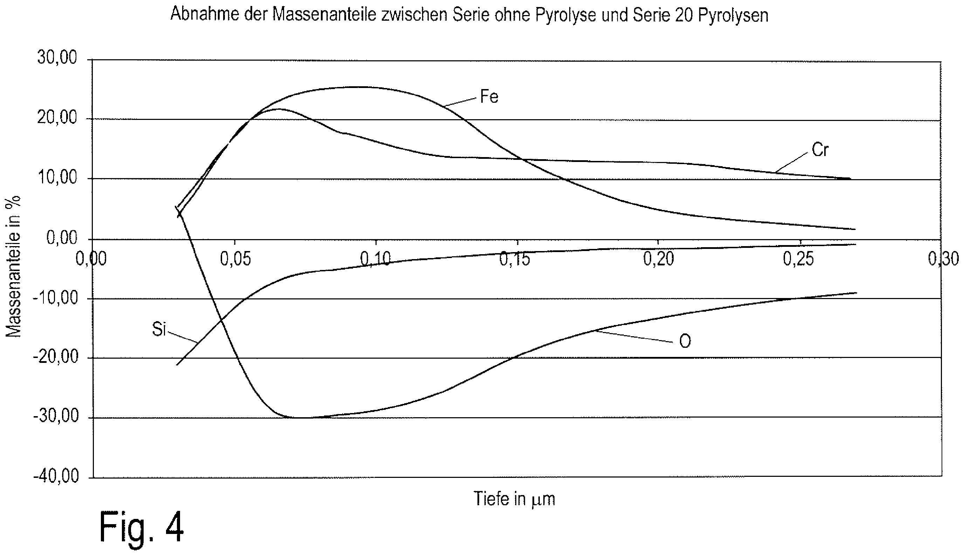

Diagramm D1 (Figur 4) gibt den Verlauf der Differenzen der Massenkonzentrationen entlang des Tiefenprofils der Eisen- Chrom- Oberfläche mit der siliziumhaltigen Beschichtung wieder. Die Differenzen ergeben sich aus Messwerten des Tiefenprofils vor und nach einer zwanzigfachen Pyrolyse. Dabei erfolgt eine Verzunderung der Edelstahloberfläche unter Ausbildung unterschiedlicher Eisen-Sauerstoff Verbindungen.

Eine Schicht aus Silizium dringt dabei lediglich zu 1-2 % in die Metalloberfläche ein.

Die Messergebnisse der Tabelle 3-5 wurden an Oberflächen durchgeführt, welche aus dem gleichen metallischen Grundmaterial, also einem legierten Edelstahl bestehen und mit einer siliziumhaltigen Plasmabeschichtung versehen sind.

Die Meßergebnisse der Tabelle 3 zeigen die Anteile der Komponenten der Plasmapolymerbeschichtung und des Grundwerkstoffes nach dem Auftrag, ohne weitere Behandlung der Schicht.

Die Messergebnisse der Tabelle 4 zeigen die Anteile der Komponenten der Plasmapolymerbeschichtung und des Grundwerkstoffes nach fünf Pyrolysen.

Die Messergebnisse der Tabelle 5 geben die Anteile der Komponenten der Plasmapolymerbeschichtung und des Grundwerkstoffes nach zwanzig Pyrolysen an.

Dabei ist nach 5 Pyrolysen die Ausbildung einer oberflächenabdeckenden Siliziumoxidschicht abgeschlossen. Nach 20 Pyrolysen ist das Siliziumoxid zudem in die Oberfläche des Grundwerkstoffs eindiffuniert, wie die Zunahme der Massekonzentration in Tabelle 5 bei 0,21 und 0,30 µm gegenüber den Messwerten von Tabelle 5 zeigt. Somit ist die Plasmabeschichtung bei mehreren Pyrolysen zusätzlich in die Grundstoffoberfläche eingedrungen bzw. eindiffundiert und weist eine Dicke von etwa 10-30 µm, vorzugsweise 20 µm auf.

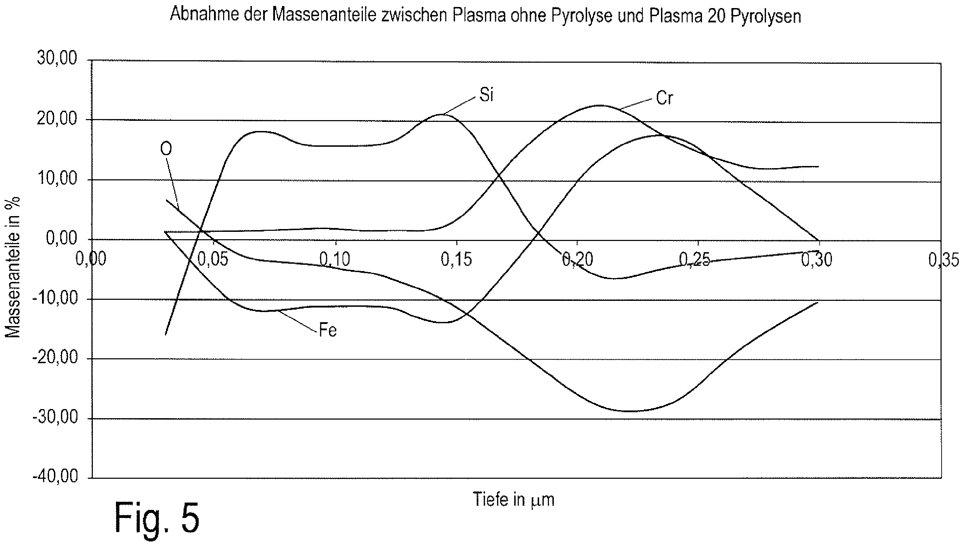

Diagramm D2 (Figur 5) zeigt den Verlauf der Differenzen der Massenkonzentrationen entlang des Tiefenprofils. Die Differenzen ergeben sich aus Messwerten des Tiefenprofils vor und nach einer zwanzigfachen Pyrolyse. Dabei wird Chrom in Tiefenbereichen unterhalb von 0,03 µm in die Silizium- bzw. siliziumoxidhaltige Schichtung der Edelstahloberfläche eingelagert. Unter und in der siliziumoxidhaltigen Oberfläche werden Chromteilchen angereichert.

Der hohe Chromanteil, welcher durch Pyrolyse in die gebildete SiO₂-Schicht eindiffundiert ist, gewährleistet die Integrität der Plasmapolymerschicht bei Kratzern durch Ausbildung von Chromoxiden. Diese Chromoxidschicht schützt die siliziumhaltige Plasmapolymerschicht vor Unterwanderung und Ablösung bei Kratzern da es zu keiner Korrosion des Stahluntergrundes kommt.

Der Chromanteil der SiO₂-Schicht nach der Pyrolyse beträgt massenanteilig durchschnittlich zwischen 5-35 %, vorzugsweise durchschnittlich 25 %.

Anlauffarben durch Schwefelverbindungen können zudem durch Einfärben der Plasmapolymerbeschichtung vorteilhaft kaschiert werden.

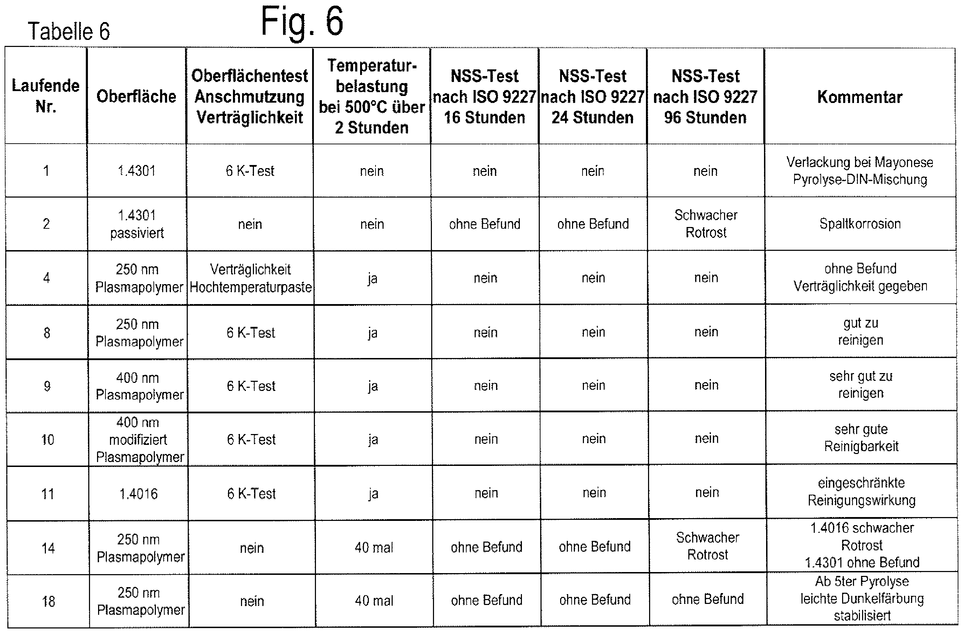

Tabelle 6 (Figur 6) zeigt Versuchsergebnisse hinsichtlich der Anhaftung von Schmutzresten, der Temperaturbelastbarkeit und der Korrosionsbeständigkeit.

Dabei wurden metallische Bauteile mit und ohne Beschichtungen und verschiedenen Schichtdicken getestet. Zum Nachweis der Temperaturbelastbarkeit wurde ein Bauteil 2 h einer Temperatur von 500 °C ausgesetzt, was in etwa den Pyrolysebedingungen in einem Backofen entspricht. Der Korrosionstest wurde nach dem Salzsprühverfahren gemäß ISO 9227 durchgeführt, wobei der Test über einen Zeitraum von 16 h, 24 h und 96 h verlief.

In einer Versuchsreihe wurde ein Bauteil mit einer Edelstahloberfläche mit der Werkstoffnummer 1.4301, also ein austenitischer säurebeständiger 18/10 Chrom-Nickel-Stahl mit niedrigem Kohlenstoffgehalt, untersucht. Dieser wies eine Verlackung bei Einwirken von Mayonese auf die Stahloberfläche auf.

In einer weiteren Versuchsreihe wurde eine passivierte Edelstahloberfläche 1.4301 untersucht. Dabei wurde während der Korrosionstest eine Spaltkorrosion der Oberfläche im Bereich der geschweißten Verbindung festgestellt.

In einem Folgeversuch wurde die Edelstahloberfläche 1.4301 mit einer Plasmapolymerschicht der Schichtdicken 120, 250 und 400 nm versehen, sowie mit einer modifizierten Plasmapolymerschicht der Schichtdicke 400 nm. Dabei wurde unabhängig von der Schichtdicke eine Verträglichkeit der Oberfläche gegenüber Anschmutzungen von Fett- bzw. Lebensmittelresten und dergl. festgestellt. Weiterhin wurde die Temperaturbeständigkeit solcher beschichteten Bauteile bestätigt.

Die Oberflächenprüfung des 6-Komponententest wird in Anlehnung an die DIN - EN 60350 durchgeführt. In den 6-komponenten sind haushaltsübliche Lebensmittel zusammengefasst, die das Spektrum der wichtigsten Stoffe zur Ernährung beinhalten.

Die 6-Komponenten enthalten Kohlenhydrate (Zucker und Stärke), Fette, Aminosäuren und Proteine (Eiweiße), Vitamine, Mineralstoffe, Ballaststoffe und Wasser. Durch die Kombination wird sichergestellt, dass die Oberflächen durch die chemische Wirkung beim Garen hinreichend belastet werden. Zweck der Anschmutzung und der anschließenden Reinigung ist es eine Vergleichbarkeit der unterschiedlichen Oberflächen herauszustellen. Die Bewertung erfolgt nach Vorgaben der o.g. Norm.

Die 6 Komponenten-Testreihe ergab eine gute bis sehr gute Reinigbarkeit der Oberfläche für alle plasmapolymerbeschichteten Bauteile. Als Belastungstest zur Temperaturbelastung wurden an den beschichteten Bauteilen mit unterschiedlichen Schichtdicken 40mal eine Pyrolysereinigung bei 500 °C über 2 h simuliert, ohne merkliche Einschränkungen in der Funktionalität der Oberfläche oder in der Integrität der Oberfläche.

Nach der jeweils 5. Pyrolyse trat jedoch eine geringe Dunkelfärbung der Beschichtung ein.

Die Korrosionstest wurden mit beschichteten Bauteilen der Schichtdicken von 120, 250 und 400 nm durchgeführt unter Verwendung von zwei verschiedenen Edlestählen.

Verwendet wurden beschichtete Bauteile aus Edelstählen der Werkstoffnummern 1.4301 und 1.4016, als einen 17 %igen Chromstahl.

Die Korrosionsbeständigkeit war bei allen drei Schichtdicken bei dem Edelstahl 1.4301 gegeben. Der beschichtete Edelstahl 1.4016 wies unabhängig von der Schichtdicke der Beschichtung lediglich bei dem Salzsprühtest über 96 h einen schwachen Rotrost auf.

Somit ist die Korrosionsbeständigkeit, die Temperaturbeständigkeit, als auch die gute Reinigbarkeit der erfindungsgemäßen plasmapolymerbeschichteten Bauteile gegeben.

Die Beschichtung bietet besondere Vorteile in Hochtemperaturanwendungsbereichen, insbesondere in Backöfen. Sie bietet jedoch auch Vorteile bei Bauteilen in Bereichen mit hoher Korrosionsgefahr. Dies umfasst beispielsweise auch die Produkte der Weißen Ware, wie z.B. Kühlschränke und Waschmaschinen. Auch Möbelbeschläge sind beim Transport, insbesondere beim Übersee-Transport, höherer Korrosionsgefahr beispielsweise durch Seewasser ausgesetzt. Auf diesen Gebieten haben beschichtete Beschläge gegenüber unbeschichteten Beschlägen eine längere Lebensdauer.

## Patentansprüche

1. Verfahren zur Herstellung von Beschlägen, Seitengittern und Gargutträgern insbesondere für Hochtemperaturanwendungen, bei dem ein metallisches Rohteil hergestellt und auf dessen Oberfläche eine Plasmapolymerschicht aufgebracht wird, **dadurch gekennzeichnet, dass**: das Rohteil vor Auftragen der Plasmapolymerschicht auf eine Oberflächenrauhigkeit von weniger als 400 nm, vorzugsweise weniger als 350 nm, geglättet wird, und
- das Rohteil nach Auftragen der Plasmapolymerschicht auf eine Temperatur von mindestens 400°C erhitzt und anschießend abgekühlt wird.

2. Verfahren nach Anspruch **1, dadurch gekennzeichnet, dass** das beschichtete Rohteil bei 400-600 °C mindestens 20 min, vorzugsweise mindestens 25 min, getempert wird.

3. Verfahren nach Anspruch 1 oder 2, **dadurch gekennzeichnet, dass** die Plasmapolymerschicht ein siliziumhaltiges Plasmapolymer, mit einer Temperaturbeständigkeit im Bereich von 300-600 °C, vorzugsweise 450- 550 °C, aufweist.

4. Verfahren nach einem der Ansprüche 1 bis 3, **dadurch gekennzeichnet, dass** in einer Aufheizphase ein erster zeitabhängiger Temperaturgradient 8-10 K/min bis zu einer mittleren Temperatur und ein zweiter zeitabhängiger Temperaturgradient 10-30 K/min bis zu einer Zieltemperatur beträgt.

5. Verfahren nach Anspruch 4, **dadurch gekennzeichnet, dass** die Zieltemperatur zwischen 400-600 °C, vorzugsweise zwischen 450-550 °C liegt und die Zieltemperatur vorzugsweise über einen Zeitraum von 15-90 Minuten, insbesondere 25 bis 40 Minuten, konstant gehalten wird.

6. Verfahren nach Anspruch 5, **dadurch gekennzeichnet, dass** ein zeitabhängiger Temperaturgradient des kontrollierten Abkühlens des Rohteils 5-40 K/min, vorzugsweise 15-25 K/min, beträgt.

7. Verfahren nach einem der Ansprüche 1-6, **dadurch gekennzeichnet, dass** beim Erhitzen des metallischen Rohteils ein Metall, insbesondere Chrom, in die Plasmapolymerschicht eindiffundiert, welches unter Sauerstoffeinfluss eine Passivschicht ausbildet.

8. Beschlag, Seitengitter oder Gargutträger, insbesondere für den Einsatz in Backöfen im Hochtemperaturbereich, mit einer Beschichtung **dadurch gekennzeichnet, dass** die Beschichtung durch ein Verfahren nach einem der Ansprüche 1-7 hergestellt ist, und wobei die Plasmapolymerschicht eine Schichtdicke von 50-500 nm aufweist.

9. Beschlag, Seitengitter oder Gargutträger nach Anspruch 8, **dadurch gekennzeichnet, dass** eine aufgetragene Plasmapolymerschicht eine korrosionsbeständige, mechanisch belastbare Siliconschicht ist.

10. Beschlag, Seitengitter oder Gargutträger nach den Ansprüchen 8 oder 9, **dadurch gekennzeichnet, dass** die Plasmapolymerschicht eine Schichtdicke von 100-400 nm aufweist.

11. Beschlag, Seitengitter oder Gargutträger nach einem der Ansprüche 8-10, **dadurch gekennzeichnet, dass** die Plasmapolymerschicht mindestens 5 %, vorzugsweise 20-30 % nach Masseanteilen ein Metall, insbesondere Chrom, aufweist, welches unter Sauerstoffeinfluss eine Passivschicht ausbildet.

12. Beschlag, Seitengitter oder Gargutträger nach einem der Ansprüche 8-11, **dadurch gekennzeichnet, dass** der metallische Grundkörper, eine darüber angeordnete Zwischenschicht, die Siliziumoxid und zumindest ein Metall aufweist, und eine Deckschicht aus Siliziumoxid aufweist, wobei die Zwischenschicht aus Siliziumoxid und Metall bei Verletzung der Deckschicht eine Passivschicht zum Schutz vor Korrosion des Grundmaterials ausbildet.

13. Beschlag, Seitengitter oder Gargutträger nach einem der Ansprüche 8-12, **dadurch gekennzeichnet, dass** die aufgetragene Plasmapolymerschicht und/oder die Beschichtung auf dem Bauteil nach dem Abkühlen transparent ist.

14. Beschlag, Seitengitter oder Gargutträger nach einem der Ansprüche 8-13, **dadurch gekennzeichnet, dass** das Bauteil als Schiene einer Auszugsführung für Backöfen ausgebildet ist.

15. Verwendung eines metallischen Beschlags, Seitengitters oder Gargutträgers nach einem der Ansprüche 8-14 in Haushaltsgeräten, insbesondere Backöfen, Kühlschranken und Waschmaschinen oder als Möbelbeschlag.

## Claims

1. A method for producing fittings, side gratings, and food supports, in particular for high-temperature applications, whereby a metal blank is produced and a plasma polymer coating is applied to a surface of the metal blank, **characterized in that**
- the blank is smoothed to a surface roughness of less than 400 nm, preferably less than 350 nm, before application of the plasma polymer layer, and
- the coated blank is heated to a temperature of at least 400°Cafter the application of the plasma polymer coating; and is cooled afterwards.

2. The method according to Claim 1, **characterized in that** the coated blank is temperature treated at 400-600°C for at least 20 minutes, preferably at least 25 minutes.

3. The method according to Claim 1 or 2, **characterized in that** the plasma polymer coating has a siliceous plasma polymer having a temperature resistance in the range of 300-600°C, preferably 450-550°C.

4. The method according to one of Claims 1 to 3, **characterized in that** in a heating phase, a first time-dependent temperature gradient is 8-10 K/minute up to a moderate temperature and a second time-dependent temperature gradient is 10-30 K/minute up to a target temperature.

5. The method according to Claim 4, **characterized in that** the target temperature is between 400-600°C, preferably between 450-550°C and the target temperature is kept constant over a period of time of 15-90 minutes, in particular 25 to 40 minutes.

6. The method according to Claim 5, **characterized in that** a time-dependent temperature gradient of the controlled cooling of the blank is 5-40 K/minute, preferably 15-25 K/minute.

7. The method according to one of Claims 1-6, **characterized in that** a metal, in particular chromium, diffuses into the plasma polymer layer, which forms a passive layer under oxygen influence, during heating of the metal blank.

8. A fitting, side grating, or food support, in particular for use in baking ovens in the high-temperature range, having a coating, **characterized in that** the coating is produced by a method according to one of claim 1-7.

9. The fitting, side grating, or food support according to Claim 8, **characterized in that** an applied plasma polymer coating is a corrosion-resistant, mechanically durable silicone layer.

10. The fitting, side grating, or food support according to Claims 8 or 9, **characterized in that** the plasma polymer layer has a layer thickness of 100-400 nm.

11. The fitting, side grating, or food support according to one of Claims 8-10, **characterized in that** the plasma polymer layer comprises at least 5%, preferably 20-30% according to mass proportions, of a metal, in particular chromium, which forms a passive layer under oxygen influence.

12. The fitting, side grating, or food support according to one of Claims 8-11, **characterized in that** the metal base body comprises an intermediate layer situated above it, which comprises silicon oxide and at least one metal, and a cover layer made of silicon oxide, the intermediate layer made of silicon oxide and metal forming a passive layer for protecting the base material from corrosion upon damage to the cover layer.

13. The fitting, side grating, or food support according to one of Claims 8 to 12, **characterized in that** the applied plasma polymer layer and/or the coating on the component is transparent after the cooling.

14. The fitting, side grating, or food support according to one of Claims 8 to 13, **characterized in that** the component is implemented as a rail of a pullout guide for baking ovens.

15. A use of a metal fitting, side grating, or food support component according to one of Claims 8-14 in household appliances, in particular baking ovens, refrigerators, and washing machines, or as a furniture fitting.

## Revendications

1. Procédé pour la fabrication de ferrures, de grilles latérales et de supports de matières à cuire, en particulier pour des applications à haute température, dans lequel une pièce brute métallique est fabriquée et une couche de polymère est appliquée par plasma sur sa surface, **caractérisé en ce que** :
- la pièce brute est lissée avant l'application de la couche de polymère appliquée par plasma jusqu'à une rugosité de surface de moins de 400 nm, de préférence moins de 350 nm, et
- après l'application de la couche de polymère appliquée par plasma, la pièce brute est chauffée à une température d'au moins 400 °C puis refroidie.

2. Procédé selon la revendication 1, **caractérisé en ce que** la pièce brute enduite est maintenue à une température de 400 à 600 °C pendant au moins 20 min, de préférence au moins 25 min.

3. Procédé selon la revendication 1 ou 2, **caractérisé en ce que** la couche de polymère appliquée par plasma contient un polymère appliqué par plasma contenant du silicium, qui présente une résistance à haute température dans la plage de 300 à 600 °C, de préférence de 450 à 550 °C.

4. Procédé selon l'une des revendications 1 à 3, **caractérisé en ce qu'**au cours d'une phase de montée en température, un premier gradient de température dépendant du temps représente 8 à 10 K/min jusqu'à une température moyenne et un deuxième gradient de température dépendant du temps représente 10 à 30 K/min jusqu'à une température visée.

5. Procédé selon la revendication 4, **caractérisé en ce que** la température visée se situe entre 400 et 600 °C, de préférence entre 450 et 550 °C, et la température visée est maintenue constante, de préférence, pendant 15 à 90 minutes, en particulier 25 à 40 minutes.

6. Procédé selon la revendication 5, **caractérisé en ce qu'**un gradient de température dépendant du temps pour le refroidissement contrôlé de la pièce brute représente de 5 à 40 K/min, de préférence de 15 à 25 K/min.

7. Procédé selon l'une des revendications 1 à 6, **caractérisé en ce que** lors du chauffage de la pièce brute métallique, un métal, en particulier du chrome, formant une couche passive sous l'action de l'oxygène est diffusé dans la couche de polymère appliquée par plasma.

8. Ferrure, grille latérale ou support de matières à cuire, en particulier destinés à une utilisation dans des fours de cuisson à haute température, munis d'un revêtement, **caractérisés en ce que** le revêtement est fabriqué par un procédé selon l'une des revendications 1 à 7, et
dans lesquels la couche de polymère appliquée par plasma présente une épaisseur de couche de 50 à 500 nm.

9. Ferrure, grille latérale ou support de matières à cuire selon la revendication 8, **caractérisés en ce qu'**une couche de polymère appliquée par plasma est une couche de silicium résistant à la corrosion et aux contraintes mécaniques.

10. Ferrure, grille latérale ou support de matières à cuire selon la revendication 8 ou 9, **caractérisés en ce que** la couche de polymère appliquée par plasma présente une épaisseur de couche de 100 à 400 nm.

11. Ferrure, grille latérale ou support de matières à cuire selon l'une des revendications 8 à 10, **caractérisés en ce que** la couche de polymère appliquée par plasma contient au moins 5 %, de préférence de 20 à 30 % en poids d'un métal, en particulier de chrome, qui forme une couche passive sous l'action de l'oxygène.

12. Ferrure, grille latérale ou support de matières à cuire selon l'une des revendications 8 à 11, **caractérisés en ce que** le corps de base métallique présente une couche intermédiaire disposée par-dessus, qui contient de l'oxyde de silicium et au moins un métal, et une couche de couverture en oxyde de silicium, la couche intermédiaire en oxyde de silicium et métal formant une couche passive si la couche de couverture est endommagée, afin de protéger le matériau de base de la corrosion.

13. Ferrure, grille latérale ou support de matières à cuire selon l'une des revendications 8 à 12, **caractérisés en ce que** la couche de polymère appliquée par plasma et/ou le revêtement de la pièce sont transparents après refroidissement.

14. Ferrure, grille latérale ou support de matières à cuire selon l'une des revendications 8 à 13, **caractérisés en ce que** la pièce est réalisée comme un rail d'un guide d'extraction pour des fours de cuisson.

15. Utilisation d'une ferrure, d'une grille latérale ou d'un support de matières à cuire selon l'une des revendications 8 à 14 dans des appareils ménagers, en particulier des fours de cuisson, des réfrigérateurs et des machines à laver ou comme ferrure de meuble.
